# EUROPEAN PATENT APPLICATION

(11) **EP 4 488 794 A1**
(43) Date of publication of application: **08.01.2025**
(21) Application number: 23846930.8
(22) Date of filing: 21.07.2023
(51) Int. Cl.: G06F 1/16, G06F 1/20, G09F 9/30, H04M 1/02

(54) **FLEXIBLE DISPLAY AND ELECTRONIC DEVICE COMPRISINIG SAME**

(30) Priority: 27.07.2022 KR 20220093441; 07.10.2022 KR 20220128887
(71) Applicant: Samsung Electronics Co., Ltd., Suwon-si, Gyeonggi-do 16677 (KR)
(72) Inventor: OH, Hyunchul, Suwon-si, Gyeonggi-do 16677 (KR); KIM, Yongwoon, Suwon-si, Gyeonggi-do 16677 (KR); GOO, Ganghyun, Suwon-si, Gyeonggi-do 16677 (KR); SIM, Youngbae, Suwon-si, Gyeonggi-do 16677 (KR); LEE, Hanyoung, Suwon-si, Gyeonggi-do 16677 (KR); JANG, Kyungok, Suwon-si, Gyeonggi-do 16677 (KR); AN, Jinwan, Suwon-si, Gyeonggi-do 16677 (KR)
(74) Representative: HGF
(86) International application number: PCT/KR2023/010609
(87) International publication number: WO 2024/025271

(57) **Abstract**

An electronic device according to one embodiment of the present disclosure may comprise: a housing including a first housing and a second housing; a hinge structure for connecting the first housing and the second housing such that same are rotatable; a flexible display arranged on the housing; at least one radiation sheet arranged between the first housing and the flexible display; and a cushion member arranged between the second housing and the flexible display. Other various embodiments are possible.

## Description

### [Technical Field]

Various embodiments disclosed herein relate to an electronic devices, for example, to a flexible display and an electronic device including the same.

### [Background Art]

With the remarkable development of information communication technology, semiconductor technology, and the like, the distribution and use of various electronic devices are rapidly increasing. In particular, recent electronic devices are being developed to be portable and capable of communication.

The term "electronic device" may refer to a device that performs a specific function according to a program installed therein, such as a home appliance, an electronic scheduler, a portable multimedia player, a mobile communication terminal, a tablet PC, an image and sound device, a desktop or laptop PC, or a vehicle navigation system. For example, these electronic devices may output stored information as sound or images. As the integration degree of electronic devices increases and ultra-high-speed and high-capacity wireless communication become more widespread, a single electronic device such as a mobile communication terminal may now be equipped with various functions. For example, not only communication functions, but also entertainment functions such as gaming, multimedia functions such as music and video playback, communication and security functions for services like mobile banking, as well as schedule management, and electronic wallet functions, are being integrated into a single electronic device. These electronic devices are being miniaturized to be conveniently carried by users.

### [Detailed Description of the Invention]

### [Technical Solution]

According to an embodiment of the disclosure, an electronic device may include a housing, a hinge structure, a flexible display, at least one heat-dissipation sheet, or a cushion member. The housing may include a first housing or a second housing. The hinge structure may rotatably connect the first housing and the second housing. The flexible display may be disposed on the housing. The at least one heat-dissipation sheet may be disposed between the first housing and the flexible display. The cushion member may be disposed between the second housing and the flexible display. The cushion member may include a first cushion member or a second cushion member. At least a portion of the first cushion member may be disposed between at least a portion of the hinge structure and the flexible display. The first cushion member may be spaced apart from the flexible display by a first distance. The second cushion member may be disposed adjacent to the first cushion member. The second cushion member may be spaced apart from the flexible display by a second distance smaller than the first distance.

According to an embodiment of the disclosure, an electronic device may include a housing, a hinge structure, a flexible display, at least one heat-dissipation sheet, or a cushion member. The housing may include a first housing or a second housing. The hinge structure may rotatably connect the first housing and the second housing. The flexible display may be disposed on the housing. The at least one heat-dissipation sheet may be disposed between the first housing and the flexible display. The cushion member may be disposed between the second housing and the flexible display. The cushion member may include a first cushion member or a second cushion member. At least a portion of the first cushion member may be disposed between at least a portion of the hinge structure and the flexible display. The first cushion member may have a first thickness in a first direction. The second cushion member may be disposed adjacent to the first cushion member. The second cushion member may have a second thickness greater than the first thickness in the first direction.

### [Brief Description of Drawings]

FIG. 1 is a block diagram of an electronic device according to various embodiments in a network environment.
FIG. 2 is a view illustrating an electronic device according to an embodiment of the disclosure in an unfolded state.
FIG. 3 is a view illustrating the electronic device according to an embodiment of the disclosure in the folded state.
FIG. 4 is an exploded perspective view of an electronic device according to an embodiment of the disclosure.
FIG. 5 is a view illustrating a housing and a camera decoration member of an electronic device according to an embodiment of the disclosure.
FIG. 6 is a view illustrating a heat-dissipation sheet and a cushion member of an electronic device according to an embodiment of the disclosure.
FIG. 7 is a cross-sectional view of an electronic device according to an embodiment of the disclosure.
FIG. 8 is a cross-sectional view of an electronic device according to an embodiment of the disclosure.
FIG. 9 is a cross-sectional view of an electronic device according to an embodiment of the disclosure.
FIG. 10 is a cross-sectional view of an electronic device according to an embodiment of the disclosure.

### [Mode for Carrying out the Invention]

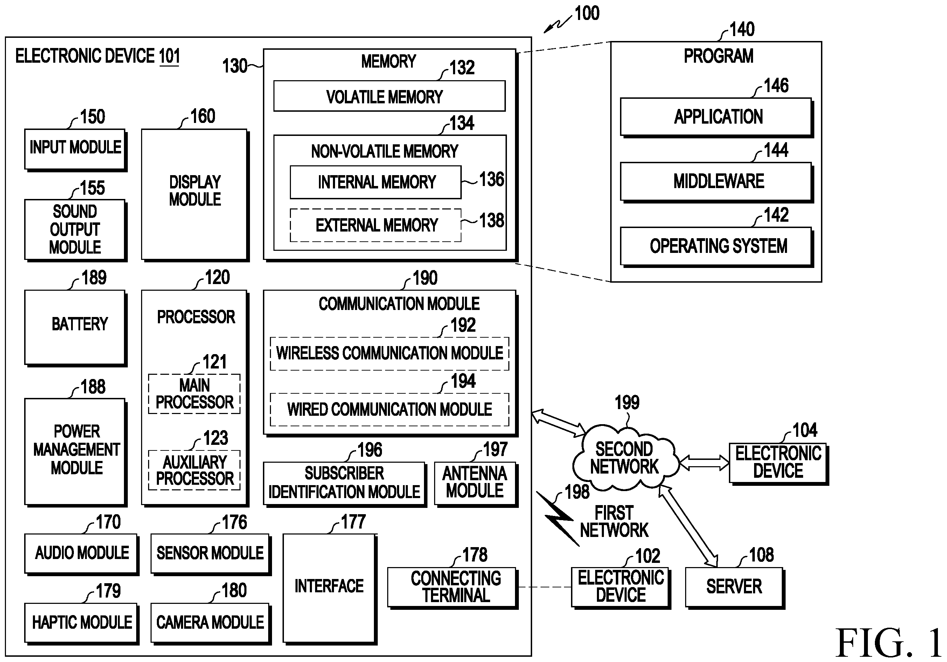

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

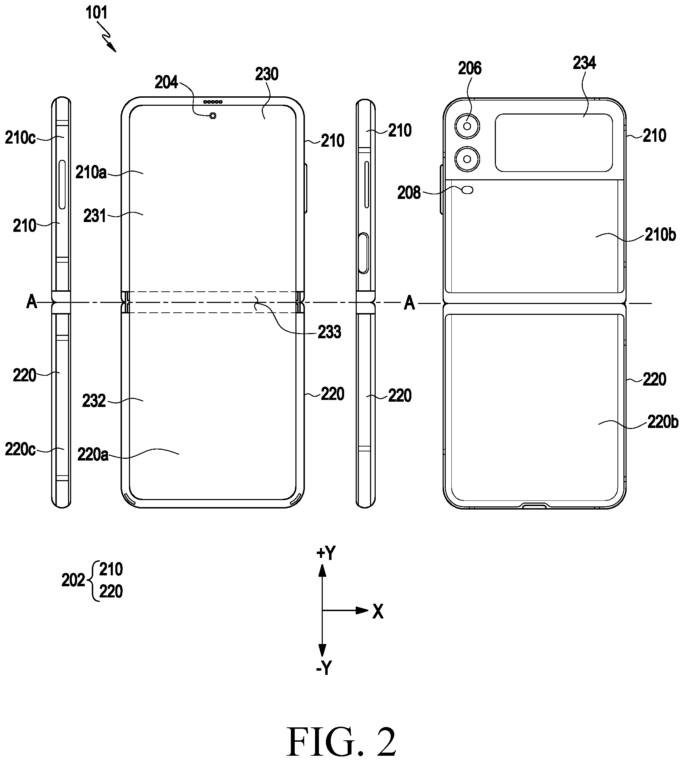

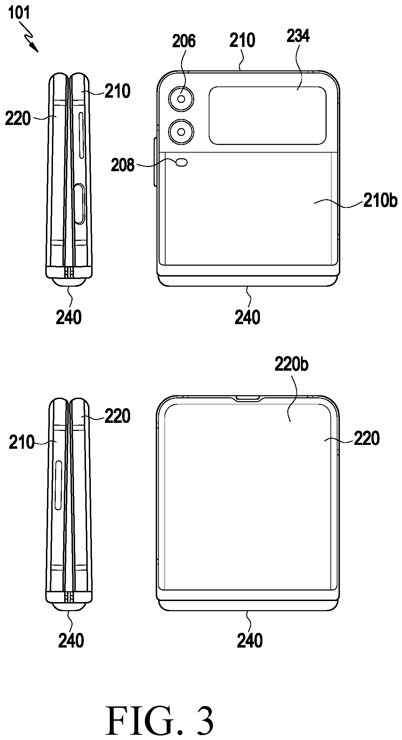

FIG. 2 is a view illustrating an electronic device according to an embodiment of the disclosure in an unfolded state. FIG. 3 is a view illustrating the electronic device according to an embodiment of the disclosure in the folded state.

The configuration of the electronic device 101 of FIGS. 2 and 3 may be wholly or partly the same as that of the electronic device 101 of FIG. 1.

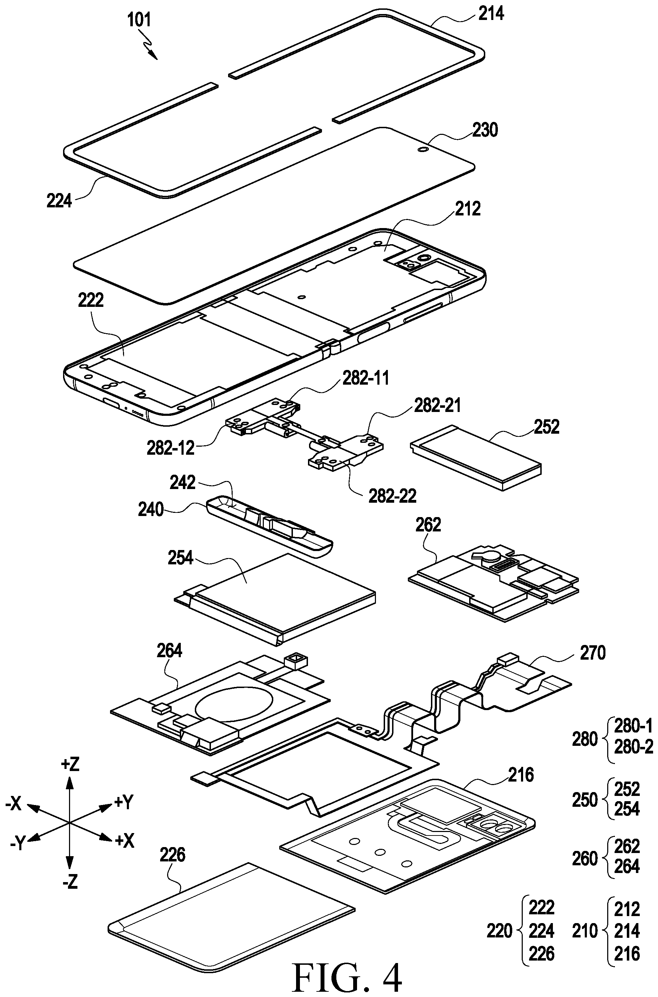

The embodiments of FIGS. 2 and 3 may be combined with the embodiment of FIG. 1 or the embodiments of FIGS. 4 to 10.

Referring to FIGS. 2 and 3, the electronic device 101 may include a housing 202 configured to accommodate components of the electronic device 101 (e.g., the hinge structure 280 in FIG. 4) and a flexible display (hereinafter, referred to as a "display 230") disposed in a space defined by the housing 202. According to an embodiment, the housing 202 may be referred to as a "foldable housing". According to an embodiment, the display 230 may be referred to as a "foldable display".

According to an embodiment, the housing 202 may include a first housing 210 and a second housing 220 configured to rotate relative to the first housing 210.

According to an embodiment, the first housing 210 and/or the second housing 220 may define at least a portion of the exterior of the electronic device 101. According to an embodiment, the surface on which the display 230 is visually exposed is defined as the front surface (e.g., a first front surface 210a and a second front surface 220a) of the electronic device 101 and/or the housing 202. The surface opposite to the front surface is defined as the rear surface (e.g., a first rear surface 210b and a second rear surface 220b) of the electronic device 101. The surface surrounding at least a portion of the space between the front and rear surfaces is defined as the side surface (e.g., a first side surface 210c and a second side surface 220c) of the electronic device 101.

According to an embodiment, the first housing 210 may be rotatably connected to the second housing 220 using a hinge structure (e.g., the hinge structure 280 in FIG. 4). For example, the first housing 210 and the second housing 220 may each be rotatably connected to the hinge structure 280. Accordingly, the electronic device 101 may change to a folded state (e.g., FIG. 3) or an unfolded state (e.g., FIG. 2). When the electronic device 101 is in the folded state, the first front surface 210a may face the second front surface 220a, and when the electronic device 200 is in the unfolded state, the direction where the first front surface 210a is oriented may be substantially the same as the direction where the second front surface 220a is oriented. For example, in the unfolded state, the first front surface 210a may be located on substantially the same plane as the second front surface 220a. According to an embodiment, the second housing 220 may move relative to the first housing 210.

According to an embodiment, the first housing 210 and the second housing 220 may be disposed on opposite sides about the folding axis A and may have generally symmetrical shapes with respect to the folding axis A. The angle between the first housing 210 and the second housing 220 may be changed depending on whether the electronic device 101 is in the unfolded state, the folded state, or an intermediate state between the unfolded state and the folded state.

According to an embodiment, the electronic device 101 may include a hinge cover 240. At least a portion of the hinge cover 240 may be disposed between the first housing 210 and the second housing 220. According to an embodiment, depending on the state of the electronic device 101, the hinge cover 240 may be covered by portions of the first housing 210 and the second housing 220 or may be exposed to the outside of the electronic device 101. According to an embodiment, the hinge cover 240 may protect the hinge structure (e.g., the hinge structure 280 in FIG. 4) from external impacts to the electronic device 101. According to an embodiment, the hinge cover 240 may be interpreted as a hinge housing to protect the hinge structure (e.g., the hinge structure 280 in FIG. 4).

According to an embodiment, as illustrated in FIG. 2, when the electronic device 101 is in the unfolded state, the hinge cover 240 may not be exposed by being covered by the first housing 210 and the second housing 220. As another example, as illustrated in FIG. 3, when the electronic device 101 is in the folded state (e.g., the fully folded state), the hinge cover 240 may be exposed to the outside between the first housing 210 and the second housing 220. As another example, when the first housing 210 and the second housing 220 are in the intermediate state in which the first and second housings are folded with a certain angle therebetween, the hinge cover 240 may be partially exposed to the outside between the first housing 210 and the second housing 220. However, in this case, the exposed area may be smaller than that in the fully folded state. In an embodiment, the hinge cover 240 may include a curved surface.

According to an embodiment, the display 230 may visually provide information to the outside of the electronic device 101 (e.g., a user). The display 230 may include, for example, a hologram device or a projector, and a control circuit to control the corresponding device. According to an embodiment, the display 230 may include a touch sensor configured to detect a touch or a pressure sensor configured to measure the intensity of force generated by the touch.

According to an embodiment, the display 230 may refer to a display, at least a portion of which is transformable into a planar surface or a curved surface. For example, the display 230 may be configured to vary in response to the relative movement of the second housing 220 with respect to the first housing 210. According to an embodiment, the display 230 may include a folding area 233, and a first display area 231 disposed on one side (e.g., above (in the +Y direction)) of the folding area 233 and a second display area 232 disposed on the other side (e.g., below (in the -Y direction)) with respect to the folding area 233. According to an embodiment, the folding area 233 may be located above the hinge structure (e.g., the hinge structure 280 in FIG. 4). For example, at least a portion of the folding area 233 may face the hinge structure 280. According to an embodiment, the first display area 231 may be disposed on the first housing 210, and the second display area 232 may be disposed on the second housing 220. According to an embodiment, the display 230 may be accommodated in the first housing 210 and the second housing 220.

However, the regional division of the display 230 illustrated in FIG. 2 is exemplary, and the display 230 may be divided into multiple (e.g., four or more or two) areas depending on its structure or function.

In addition, in the embodiment illustrated in FIG. 2, the areas of the display 230 may be divided by the folding area 233 or the folding axis (the axis A) extending in parallel to the X-axis. However, in another embodiment, the areas of the display 230 may be divided with reference to another folding area (e.g., a folding area parallel to the Y-axis) or another folding axis (e.g., a folding axis parallel to the Y-axis). According to an embodiment, the display 230 may be coupled to or disposed adjacent to a touch detection circuit, a pressure sensor that is capable of measuring touch intensity (pressure), and/or a digitizer configured to detect a magnetic field-type stylus pen.

According to an embodiment, the electronic device 101 may include a rear display 234. The rear display 234 may be disposed to be oriented in a different direction from the display 230. For example, the display 230 may be visually exposed through the front surface (e.g., the first front surface 210a and/or the second front surface 220a) of the electronic device 101, and the rear display 234 may be visually exposed through the rear surface (e.g., the first rear surface 210b) of the electronic device 101.

According to an embodiment, the electronic device 101 may include one or more camera modules 204 and 206 and a flash 208. According to an embodiment, the electronic device 101 may include a front camera module 204 exposed through the front surface (e.g., the first front surface 210a) and/or a rear camera module 206 exposed through the rear surface (e.g., the first rear surface 220b). The camera modules 204 and 206 may include one or more lenses, image sensors, flashes, and/or image signal processors. The flash 208 may include a light-emitting diode or xenon lamp. According to an embodiment, two or more lenses (e.g., an infrared camera lens, a wide-angle lens, and a telephoto lens) and image sensors may be disposed on one surface of the electronic device 101. The configuration of the front camera module 204 and/or the rear camera module 206 may be entirely or partially identical to the configuration of the camera module 180 of FIG. 1.

In the drawings referenced in the following description, a spatial coordinate system is illustrated for the convenience of explanation. In the spatial coordinate system, the X-axis direction, the Y-axis direction, and the Z-axis direction may be defined and interpreted as the width direction, the length direction, and the thickness direction of the electronic device and its components, respectively.

FIG. 4 is an exploded perspective view of an electronic device according to an embodiment of the disclosure.

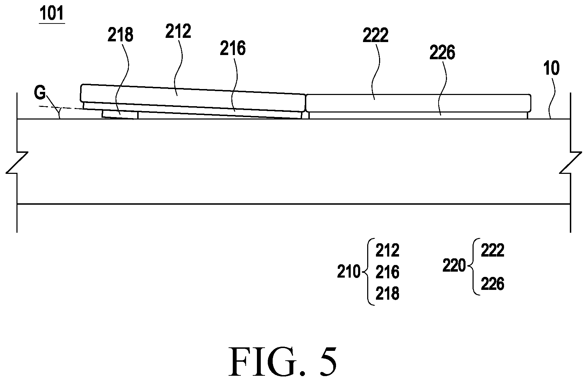

The embodiment of FIG. 4 may be combined with the embodiments of FIGS. 1 to 3 and the embodiments of FIGS. 5 to 10.

Referring to FIG. 4, the electronic device 201 may include a first housing 210, a second housing 220, a display 230, a hinge cover 240, a battery 250, a printed circuit board 260, a flexible printed circuit board 270, and a hinge structure 280. The configurations of the first housing 210, the second housing 220, the display 230, and the hinge cover 240 of FIG. 4 may be entirely or partially identical to those of the first housing 210, the second housing 210, the display 230, and the hinge cover 240 of FIG. 2 and/or FIG. 3.

According to an embodiment, the electronic device 101 may include a first support member 212 and a second support member 222. For example, the first housing 210 may include a first support member 212, and the second housing 220 may include a second support member 222. According to an embodiment, the first support member 212 and/or the second support member 222 may support components of the electronic device 101 (e.g., the display 230, the battery 250, and the printed circuit board 260).

According to an embodiment, the first support member 212 and/or the second support member 222 may be made of a metal material and/or a non-metal (e.g., polymer) material. According to an embodiment, the first support member 212 may be disposed between the display 230 and the battery 250. For example, the display 230 may be coupled to one surface of the first support member 212, and the battery 250 and the printed circuit board 260 may be disposed on the other surface.

According to an embodiment, the electronic device 101 may include a first protective member 214 and a second protective member 224. For example, the first housing 210 may include the first protective member 214, and the second housing 220 may include the second protective member 224. According to an embodiment, the protective members 214 and 224 may protect the display 230 from external impacts. For example, the first protective member 214 may surround at least a portion of the display 230 (e.g., the first display area 231 in FIG. 2), and the second protective member 224 may surround at least a portion of another portion of the display 230 (e.g., the second display area 232 in FIG. 2). According to an embodiment, the first protective member 214 may be referred to as a "first protective member", and the second protective member 214 may be referred to as a "second protective member".

According to an embodiment, the housings 210 and 220 may include a first rear surface plate 216 and a second rear surface plate 226. For example, the first housing 210 may include the first rear surface plate 216 connected to the first support member 212, and the second housing 220 may include the second rear surface plate 216 connected to the second support member 222. According to an embodiment, the rear surface plates 216 and 226 may define a portion of the exterior of the electronic device 101. For example, the first rear surface plate 216 may define the first rear surface (e.g., the first rear surface 210b in FIGS. 2 and 3), and the second rear surface plate 226 may define the second rear surface (e.g., the second rear surface 220b in FIG. 2 and 3). According to an embodiment, a first battery 252 and a first printed circuit board 262 may be disposed between the first support member 212 and the first rear surface plate 216, and a second battery 254 and a second printed circuit board 264 may be disposed between the second support member 222 and the second rear surface plate 226.

According to an embodiment, the hinge cover 240 may accommodate at least a portion of the hinge structure 280. For example, the hinge cover 240 may include an accommodation groove 242 to accommodate the hinge structure 280. According to an embodiment, the hinge cover 240 may be coupled with the hinge structure 280. According to an embodiment, when the electronic device 101 is in the unfolded state, at least a portion of the hinge cover 240 may be located between the hinge structure 280 and the housings 210 and 220.

According to an embodiment, the battery 250 is a device to supply power to at least one component of the electronic device 101, and may include a non-rechargeable primary battery, a rechargeable secondary battery, or a fuel cell. The battery 250 may be integrally disposed inside the electronic device 101 or may be detachably disposed on the electronic device 101. According to an embodiment, the battery 250 may include a first battery 252 disposed in the first housing 210 and a second battery 254 disposed in the second housing 220. For example, the first battery 252 may be disposed on the first support member 212, and the second battery 254 may be disposed on the second support member 222.

According to an embodiment, a processor (e.g., the processor 220 in FIG. 1), memory (e.g., the memory 230 in FIG. 1), and/or an interface (e.g., the interface 277 in FIG. 1) may be mounted on the printed circuit board 260. According to an embodiment, the printed circuit board 260 may include a first printed circuit board 262 disposed in the first housing 210 and a second printed circuit board 264 disposed in the second housing 220.

According to an embodiment, the flexible printed circuit board (FPCB) 270 may electrically interconnect a component located in the first housing 210 (e.g., the first printed circuit board 262) and a component located in the second housing 220 (e.g., the second printed circuit board 264). According to an embodiment, at least a portion of the flexible printed circuit board 270 may cross the hinge cover 240 and/or the hinge structure 280. For example, a portion of the flexible printed circuit board 270 may be disposed within the first housing 210 and another portion may be disposed within the second housing 220. According to an embodiment, the flexible printed circuit board 270 may be connected to an antenna or may be connected to the display 230.

According to an embodiment, the hinge structure 280 may be connected to the first housing 210 and the second housing 220. According to an embodiment, the first housing 210 may rotate relative to the second housing 220 using the hinge structure 280. According to an embodiment, the hinge structure 280 may interconnect the first housing 210 and the second housing 220 to be rotatable from the folded state (e.g., FIG. 3) to the unfolded state (e.g., FIG. 2).

According to an embodiment, the hinge structure 280 may include multiple hinge structures 280-1 and 280-2 arranged in parallel to each other. For example, the hinge structure 280 may include a first hinge structure 280-1 and a second hinge structure 280-2 spaced apart from the first hinge structure 280-1. According to an embodiment, the first hinge structure 280-1 and the second hinge structure 280-2 may be symmetrical to each other with respect to the length direction of the electronic device 101 (e.g., the Y-axis direction).

According to an embodiment, the first hinge structure 280-1 may relatively rotatably interconnect the first support member 212 and the second support member 222. According to an embodiment, the first hinge structure 280-1 may include a (1-1)^{th} hinge structure 280-11 and a (1-2)^{th} hinge structure 280-12. For example, the (1-1)^{th} hinge structure 280-11 may be connected to the first support member 212, and the (1-2)^{th} hinge structure 280-12 may be connected to the second support member 222.

According to an embodiment, the second hinge structure 280-2 may relatively rotatably interconnect the first support member 212 and the second support member 222. According to an embodiment, the second hinge structure 280-2 may be spaced apart from the first hinge structure 280-1. According to an embodiment, the second hinge structure 280-2 may include a (2-1)^{th} hinge structure 280-21 and a (2-2)^{th} hinge structure 280-22. For example, the (2-1)^{th} hinge structure 280-21 may be connected to the first support member 212, and the (2-2)^{th} hinge structure 280-22 may be connected to the second support member 222.

FIG. 5 is a view illustrating a housing and a camera decoration member of an electronic device according to an embodiment of the disclosure.

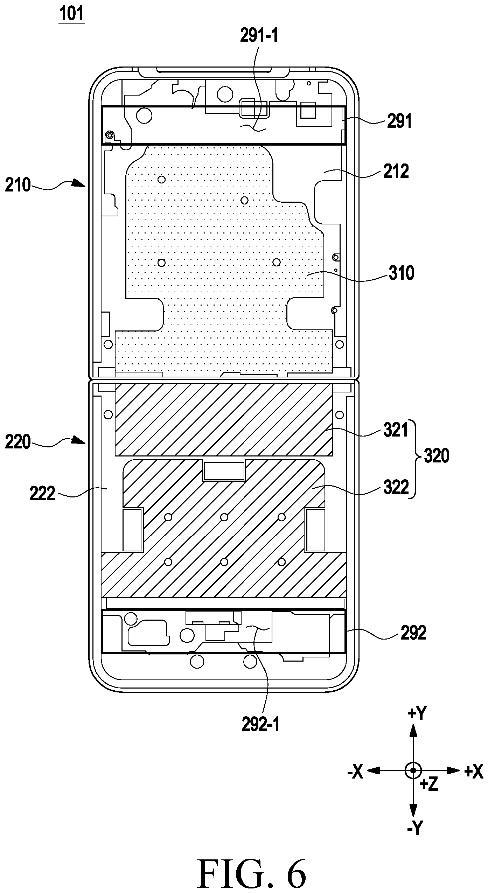

The embodiment of FIG. 5 may be combined with the embodiments of FIGS. 1 to 4 or the embodiments of FIGS. 6 to 10.

Referring to FIG. 5, the electronic device 101 (e.g., the electronic device 101 in FIGS. 1 to 4) may include a first housing 210, or a second housing 220 rotatably connected to the first housing 210.

The configuration of the first housing 210 or the second housing 220 of FIG. 5 may be entirely or partially identical to the configuration of the first housing 210 or the second housing 220 of FIG. 4.

According to an embodiment, the first housing 210 may include a first support member 212 (e.g., the first support member 212 in FIG. 4), a first rear surface plate 216 (e.g., the first rear surface plate 216 in FIG. 4), or a decoration member 218.

According to an embodiment, the second housing 220 may include a second support member 222 (e.g., the second support member 222 in FIG. 4) or a second rear surface plate 226 (e.g., the second rear surface plate 226 in FIG. 4).

According to an embodiment, at least a portion of the decoration member 218 may be disposed to be exposed (or protrude) from the first rear surface plate 216. According to an embodiment, the decoration member 218 may also be defined and referred to as a "camera decoration member". According to an embodiment, the decoration member 218 may be configured to cover a camera module (e.g., the camera module 206 in FIGS. 2 and 3) exposed through the rear surface of the first housing 210.

According to an embodiment, when the electronic device 101 is placed on the ground 10 (or another flat surface) in the unfolded state (e.g., FIG. 2 or FIG. 5), the second housing 220 may be disposed parallel to the ground 10. In addition, when the electronic device 101 is placed on the ground 10 in the unfolded state (e.g., FIG. 2 or FIG. 5), the first housing 210 may be disposed obliquely to form a predetermined angle G with respect to the ground 10 due to the decoration member 218. Accordingly, a predetermined space may be formed between the first rear plate 216 and the ground 10.

When an external impact is applied to the first housing 210 of the electronic device 101, the external impact applied to the first housing 210 may be easily distributed from the portion where the impact is applied to the first housing 210 to another portion due to the space formed due to the predetermined angle G.

When an external impact is applied to the second housing 220 of the electronic device 101, the external impact applied to the second housing 220 may be difficult to easily disperse from the portion where the impact is applied to the second housing 220 to another portion. Accordingly, it may be difficult to secure durability for a portion of the display placed on the second housing 220 against the external impact applied to the second housing 220.

FIG. 6 is a view illustrating a heat-dissipation sheet and a cushion member of an electronic device according to an embodiment of the disclosure.

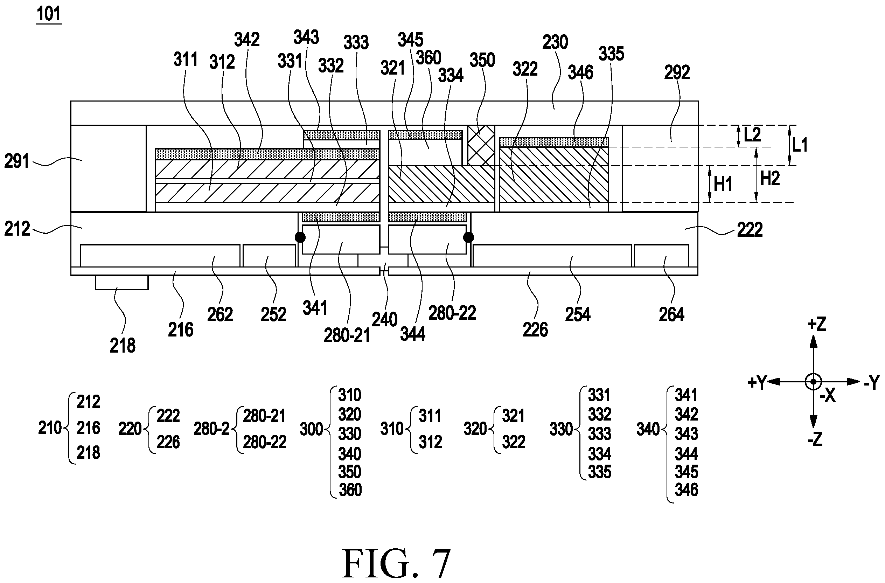

The embodiment of FIG. 6 may be entirely or partially identical to the embodiments of FIGS. 1 to 5 or the embodiments of FIGS. 7 to 10.

Referring to FIG. 6, an electronic device 101 (e.g., the electronic device 101 in FIGS. 1 to 5) may include a first housing 210 including a first support member 212, a second housing 220 including a second support member 222, at least one heat-dissipation sheet 310, a cushion member 320, a first waterproof member 291, or a second waterproof member 292.

The configuration of the first housing 210 including the first support member 212 or the second housing (220) including the second support member 222 in FIG. 6 may be entirely or partially identical to the configuration of the first housing 210 including the first support member 212 or the second housing 220 including the second support member 222 in FIG. 4.

According to an embodiment, at least one heat-dissipation sheet 310 may be disposed on the first housing 210. For example, at least one heat-dissipation sheet 310 may be at least partially disposed between the first support member 212 and the flexible display (e.g., the flexible display 230 in FIG. 4).

According to an embodiment, the at least one heat-dissipation sheet 310 may be configured to receive heat generated from a first printed circuit board (e.g., the first printed circuit board 262 in FIG. 4) disposed on the first support member 212 or electrical components disposed in the first housing 210. For example, the at least one heat-dissipation sheet 310 may receive heat generated from the first printed circuit board or electrical components and dissipate the received heat in the plane direction of the heat-dissipation sheet 310 (e.g., the plane direction defined by the X-axis and the Y-axis in FIG. 5). According to an embodiment, the at least one heat-dissipation sheet 310 may include at least one of a graphite sheet, a copper sheet, or a metal sheet.

According to an embodiment, the cushion member 320 may be disposed on the second housing 220. For example, the cushion member 320 may be at least partially disposed between the second support member 222 and the flexible display (e.g., the flexible display 230 in FIG. 4).

According to an embodiment, the cushion member 320 may be configured to absorb an external impact applied to the second housing 220 or the flexible display (e.g., the flexible display 230 in FIG. 4). For example, the cushion member 320 may be a sponge member configured to absorb the external impact while being deformed by the external impact, but is not limited thereto.

According to an embodiment, the cushion member 320 may be a high-performance compression force deflection (CFD) or high-elasticity sponge member. According to an embodiment, the cushion member 320 may have a 25% CFD value (e.g., the force required to compress the cushion member by 25%) of 0.25 MPa, but is not limited thereto.

According to an embodiment, the cushion member 320 may include a first cushion member 321 or a second cushion member 322.

According to an embodiment, the first cushion member 321 may be at least partially disposed between the hinge structure (e.g., the hinge structure 280 in FIG. 4) and the flexible display (e.g., the flexible display 230 in FIG. 4). For example, the first cushion member 321 may be at least partially disposed between the hinge structure and at least a portion of the flexible display (e.g., the folding area 233 in FIG. 2).

According to an embodiment, the first cushion member 321 may be disposed between the at least one heat-dissipation sheet 310 and the second cushion member 322 when the electronic device 101 is in the unfolded state (e.g., FIG. 2 or FIGS. 7 to 10). According to an embodiment, the first cushion member 321 may be disposed between the hinge cover (e.g., the hinge cover 240 in FIG. 4) and the second cushion member 322 when the electronic device 101 is in the folded state (e.g., FIG. 3).

According to an embodiment, the second cushion member 322 may be at least partially disposed between the second support member 222 and the flexible display (e.g., the flexible display 230 in FIG. 4). For example, the second cushion member 322 may be at least partially disposed between the second support member 222 and at least a portion of the flexible display (e.g., the second display area 232 in FIG. 2). The second cushion member 322 may be disposed between the first cushion member 321 and the second waterproof member 292 with reference to the length direction of the electronic device 101 (e.g., the Y-axis direction in FIG. 6).

According to an embodiment, when the electronic device 101 is in the unfolded state (e.g., FIG. 2 or FIG. 6), the at least one heat-dissipation sheet 310 may be disposed closer to the first cushion member 321 than to the second cushion member 322. According to an embodiment, when the electronic device 101 is in the unfolded state, the first cushion member 321 may be disposed between the at least one heat-dissipation sheet 310 and the second cushion member 322.

According to an embodiment, the first waterproof member 291 may be disposed between the first housing 210 and the flexible display (e.g., the flexible display 230 in FIG. 4). According to an embodiment, the first waterproof member 291 may be disposed between the first support member 212 and the first display area (e.g., the first display area 231 in FIG. 2). According to an embodiment, the first waterproof member 291 may include a waterproof tape.

According to an embodiment, the first waterproof member 291 may be bonded to the first housing 210 (or the first support member 212) and the flexible display (e.g., the flexible display 230 in FIG. 2) (or the first display area 231). According to an embodiment, the first waterproof member 291 may include a closed loop shape.

For example, the first waterproof member 291 may include at least one closed loop area 291-1. The first waterproof member 291 may limit liquid inflow from the exterior of the closed loop area 291-1 to the interior of the closed loop area 291-1. According to an embodiment, the closed loop area 291-1 of the first waterproof member 291 may be defined and referred to as a "first waterproof area 291-1".

According to an embodiment, the second waterproof member 292 may be disposed between the first housing 210 and the flexible display (e.g., the flexible display 230 in FIG. 4). According to an embodiment, the second waterproof member 292 may be disposed between the first support member 222 and the second display area (e.g., the second display area 232 in FIG. 2). According to an embodiment, the second waterproof member 292 may include a waterproof tape.

According to an embodiment, the second waterproof member 292 may be bonded to the second housing 220 (or the second support member 222) and the flexible display (e.g., the flexible display 230 in FIG. 2) (or the second display area 232). According to an embodiment, the second waterproof member 292 may include a closed loop shape.

For example, the second waterproof member 292 may include at least one closed loop area 292-2. The second waterproof member 292 may limit liquid inflow from the exterior of the closed loop area 292-1 to the interior of the closed loop area 292-1. According to an embodiment, the closed loop area 292-1 of the second waterproof member 292 may be defined and referred to as a "second waterproof area 292-1".

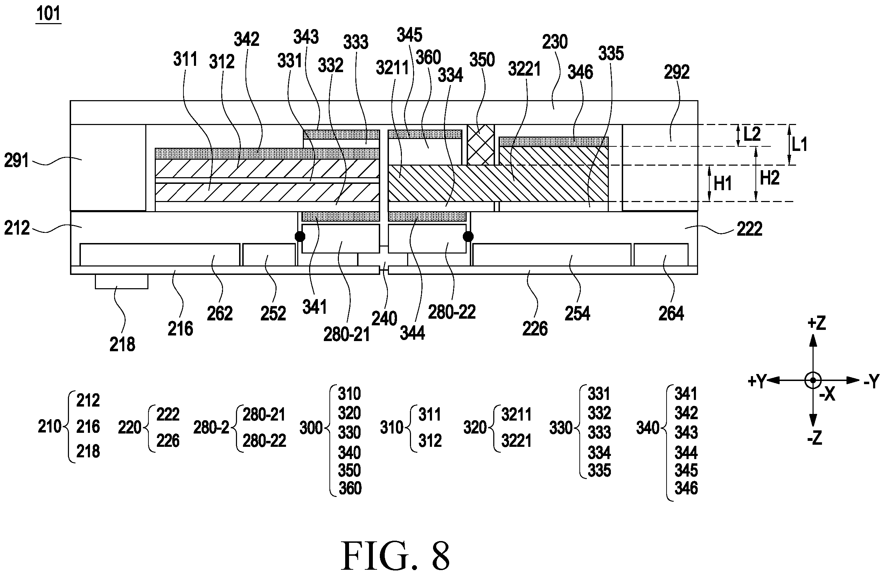

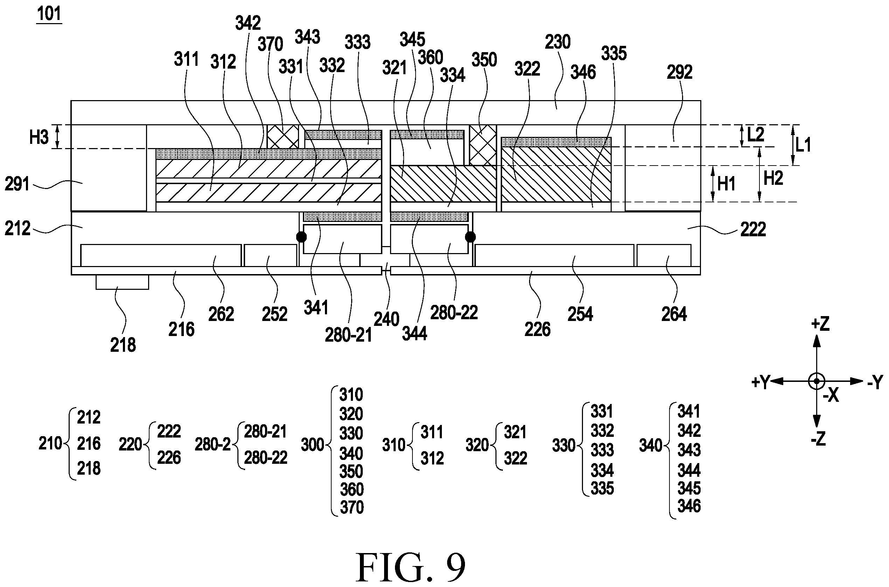

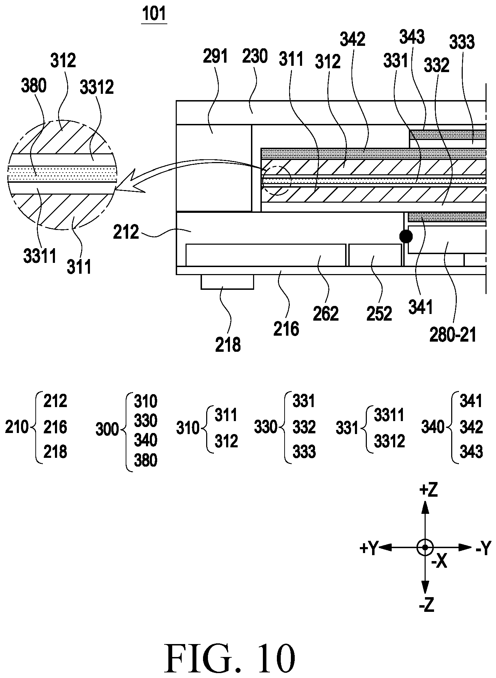

FIG. 7 is a cross-sectional view of an electronic device according to an embodiment of the disclosure. FIG. 8 is a cross-sectional view of an electronic device according to an embodiment of the disclosure. FIG. 9 is a cross-sectional view of an electronic device according to an embodiment of the disclosure. FIG. 10 is a cross-sectional view of an electronic device according to an embodiment of the disclosure.

The embodiments of FIGS. 7 to 10 may be combined with the embodiments of FIGS. 1 to 6.

Referring to FIGS. 7 to 10, an electronic device 101 (e.g., the electronic device 101 in FIGS. 1 to 6) may include a first housing 210, a second housing 220, a flexible display 230, a hinge cover 240, a first battery 252, a second battery 254, a first printed circuit board 262, a second printed circuit board 264, a second hinge structure 280-2, a first waterproof member 291, a second waterproof member 292, or a display sheet member 300.

The configuration of the first housing 210, the second housing 220, the flexible display 230, the second hinge structure 280-2, the first waterproof member 291, or the second waterproof member 292 of FIGS. 7 to 10 may be entirely or partially identical to the configuration of the first housing 210, the second housing 220, the flexible display 230, the hinge cover 240, the second hinge structure 280-2, the first waterproof member 291, or the second waterproof member 292 of FIGS. 4 to 6.

According to an embodiment, the first housing 210 may include a first support member 212 (e.g., the first support member 212 in FIG. 4), a first rear surface plate 216 (e.g., the first rear surface plate 216 in FIG. 4), or a decoration member 218 (e.g., the decoration member 218 in FIG. 5).

According to an embodiment, the second housing 220 may include a second support member 222 (e.g., the second support member 222 in FIG. 4) or a second rear surface plate 226 (e.g., the second rear surface plate 226 in FIG. 4).

According to an embodiment, the electronic device 101 may include a first battery 252 (e.g., the first battery 252 in FIG. 4) disposed on the first support member 212 and a second battery 254 (e.g., the second battery 254 in FIG. 4) disposed on the second support member 222.

According to an embodiment, the electronic device 101 may include a first printed circuit board 262 (e.g., the first printed circuit board 262 in FIG. 4) disposed within the first housing 210 and a second printed circuit board 264 (e.g., the second printed circuit board 264 in FIG. 4) disposed within the second housing 220.

According to an embodiment, the electronic device 101 may include a hinge structure (e.g., the hinge structure 280 in FIG. 4) including a first hinge structure (e.g., the first hinge structure 280-1 in FIG. 4) and a second hinge structure 280-2 (e.g., the second hinge structure 280-2 in FIG. 4). According to an embodiment, the second hinge structure 280-2 may include a (2-1)^{th} hinge structure 280-21 connected to the first support member 212, or a (2-2)^{th} hinge structure 280-22 connected to the second support member 222.

According to an embodiment, the second hinge structure 280-2 (or the first hinge structure 280-1 in FIG. 4) may not be exposed to the exterior of the electronic device 101 by the hinge cover 240 (e.g., the hinge cover 240 in FIG. 4).

According to an embodiment, the electronic device 101 may include a first waterproof member 291 (e.g., the first waterproof member 291 in FIG. 6) or a second waterproof member 292 (e.g., the second waterproof member 292 in FIG. 6).

Referring to FIGS. 7 to 10, the display sheet member 300 may include at least one heat-dissipation sheet 310, a cushion member 320, at least one first adhesive member 330, at least one cover member 340, a second adhesive member 350, or a gap adjustment member 360.

According to an embodiment, the display sheet member 300 may be disposed between the flexible display 230 and the housings 210 and 220. According to an embodiment, the display sheet member 300 may be configured to enhance the impact resistance of the flexible display 250 or to enhance the heat-dissipation performance of the electronic device 101.

According to an embodiment, at least one heat-dissipation sheet 310 may receive heat generated from the first printed circuit board 262 or the electrical components disposed on the first printed circuit board 262, and may dissipate the received heat in the plane direction of at least one heat-dissipation sheet 310 (e.g., the plane direction defined by the X-axis and the Y-axis in FIGS. 7 to 10).

According to an embodiment, the at least one heat-dissipation sheet 310 (e.g., the at least one heat-dissipation sheet 310 in FIG. 6) may include a first heat-dissipation sheet 311 or a second heat-dissipation sheet 312. According to an embodiment, the at least one heat-dissipation sheet 310 may include at least one of a graphite sheet, a copper sheet, or a metal sheet.

According to an embodiment, the first heat-dissipation sheet 311 and the second heat-dissipation sheet 312 may be bonded via the (1-1)^{th} adhesive member 331. For example, the first heat-dissipation sheet 311 and the second heat-dissipation sheet 312 may face each other with the (1-1)^{th} adhesive member 331 interposed therebetween.

According to an embodiment, at least a portion of the first heat-dissipation sheet 311 may be bonded to at least a portion of the first support member 212 via the (1-2)^{th} adhesive member 332. According to an embodiment, at least a portion of the first heat-dissipation sheet 311 may be disposed between the first support member 212 and the flexible display 230 with reference to the thickness direction of the electronic device 101 (e.g., the Z-axis direction in FIGS. 7 to 10), and the remaining other portion may be disposed between the (2-1)^{th} hinge structure 280-21 and the flexible display 230. According to an embodiment, the remaining other portion of the first heat-dissipation sheet 311 may be defined as being disposed between the (1-1)^{th} hinge structure (e.g., the (1-1)^{th} hinge structure 280-11 in FIG. 4) and the flexible display 230.

According to an embodiment, at least a portion of the second heat-dissipation sheet 312 may be bonded to the first heat-dissipation sheet 311 via the (1-1)^{th} adhesive member 331. According to an embodiment, the second heat-dissipation sheet 312 may be disposed between the first heat-dissipation sheet 311 and the flexible display 230. In addition, at least a portion of the second heat-dissipation sheet 312 may be disposed between the first support member 212 and the flexible display 230 with reference to the thickness direction of the electronic device 101 (e.g., the Z-axis direction in FIGS. 7 to 10), and the remaining other portion may be disposed between the (2-1)^{th} hinge structure 280-21 and the flexible display 230. According to an embodiment, the remaining other portion of the second heat-dissipation sheet 312 may be defined as being disposed between the (1-1)^{th} hinge structure (e.g., the (1-1)^{th} hinge structure 280-11 in FIG. 4) and the flexible display 230.

According to an embodiment, the thickness of the first heat-dissipation sheet 311 (e.g., the thickness in the Z-axis direction in FIGS. 7 to 10) may be about 64 µm to about 77 µm. According to an embodiment, the thickness of the first heat-dissipation sheet 311 may be about 70 µm.

According to an embodiment, the thickness of the second heat-dissipation sheet 312 (e.g., the thickness in the Z-axis direction in FIGS. 7 to 10) may be about 64 µm to about 77 µm. According to an embodiment, the thickness of the second heat-dissipation sheet 312 may be about 70 µm.

According to an embodiment, the cushion member 320 (e.g., the cushion member 320 in FIG. 6) may be configured to absorb an external impact applied to the second housing 220 or the flexible display 230. For example, the cushion member 320 may be a sponge member configured to absorb the external impact while being deformed by the external impact, but is not limited thereto.

According to an embodiment, the cushion member 320 may include a first cushion member 321 (e.g., the first cushion member 321 in FIG. 6) or a second cushion member 322 (e.g., the second cushion member 322 in FIG. 6).

According to an embodiment, the first cushion member 321 and the second cushion member 322 may be disposed adjacent to each other. According to an embodiment, the first cushion member 321 may be disposed between the at least one heat-dissipation sheet 310 and the second cushion member 322 when the electronic device 101 is in the unfolded state (e.g., FIG. 2 or FIGS. 7 to 10). According to an embodiment, the second cushion member 322 may be disposed between the first cushion member 321 and the second waterproof member 292 when the electronic device 101 is in the unfolded state (e.g., FIG. 2 or FIGS. 7 to 10).

According to an embodiment, at least a portion of the first cushion member 321 may be bonded to at least a portion of the second support member 222 via the (1-4)^{th} adhesive member 334. According to an embodiment, at least a portion of the first cushion member 321 may be disposed between the second support member 222 and the flexible display 230 with reference to the thickness direction of the electronic device 101 (e.g., the Z-axis direction in FIGS. 7 to 10), and the remaining other portion may be disposed between the (2-2)^{th} hinge structure 280-22 and the flexible display 230. According to an embodiment, the remaining other portion of the first cushion member 321 may be defined as being disposed between the (1-2)^{th} hinge structure (e.g., the (1-2)^{th} hinge structure 280-12 in FIG. 4) and the flexible display 230.

According to an embodiment, at least a portion of the first cushion member 321 may be bonded to at least a portion of the second support member 222 via the (1-4)^{th} adhesive member 334. According to an embodiment, at least a portion of the first cushion member 321 may be disposed between the second support member 222 and the flexible display 230 with reference to the thickness direction of the electronic device 101 (e.g., the Z-axis direction in FIGS. 7 to 10), and the remaining other portion may be disposed between the (2-2)^{th} hinge structure 280-22 and the flexible display 230. According to an embodiment, the remaining other portion of the first cushion member 321 may be defined as being disposed between the (1-2)^{th} hinge structure (e.g., the (1-2)^{th} hinge structure 280-12 in FIG. 4) and the flexible display 230.

According to an embodiment, at least a portion of the second cushion member 321 may be bonded to at least a portion of the second support member 222 via the (1-5)^{th} adhesive member 335. According to an embodiment, the second cushion member 321 may be disposed between the second support member 222 and the flexible display 230 with reference to the thickness direction of the electronic device 101 (e.g., the Z-axis direction in FIGS. 7 to 10).

According to an embodiment, when the electronic device 101 is in the unfolded state (e.g., FIG. 2 or FIGS. 7 to 10), the first cushion member 321 may be spaced apart from the flexible display 230 by a first distance L1. The first distance L1 may be a distance in a first direction (e.g., the Z-axis direction in FIGS. 7 to 10). According to an embodiment, the first direction may be defined as the thickness direction of the electronic device 101. The first direction may be defined as the direction from the second rear surface plate 226 toward the flexible display 230 or *vice versa.*

According to an embodiment, when the electronic device 101 is in the unfolded state (e.g., FIG. 2 or FIGS. 7 to 10), the second cushion member 322 may be spaced apart from the flexible display 230 by a second distance L2. The second distance L2 may be a distance in the first direction. According to an embodiment, the second distance L2 may be smaller (or shorter) than the first distance L1.

According to an embodiment, when the electronic device 101 is in the unfolded state (e.g., FIG. 2 or FIGS. 7 to 10), the first thickness H1, which is the thickness of the first cushion member 321 in the first direction, may be smaller (or thinner) than the second thickness H2, which is the thickness of the second cushion member 322 in the first direction.

According to an embodiment, the first cushion member 321 or the second cushion member 322 may absorb an external impact applied to the second housing 220 or the flexible display 230. Accordingly, the impact resistance of the second housing 220 or the flexible display 230 may be improved. In addition, since the external impact applied to at least a portion of the flexible display 230 is appropriately distributed, the occurrence of cracks or damage in the portion of the flexible display 230 to which the impact is applied may be reduced.

According to an embodiment, at least one first adhesive member 330 may bond the components of the display sheet member 300 to other components. According to an embodiment, at least one first adhesive member 330 may include at least one of a pressure-sensitive adhesive (PSA), an optical clear adhesive (OCA), a heat-reactive adhesive, a general adhesive, or a double-sided tape.

According to an embodiment, at least one first adhesive member 330 may include a (1-1)^{th} adhesive member 331, a (1-2)^{th} adhesive member 332, a (1-3)^{th} adhesive member 333, a (1-4)^{th} adhesive member 334, or a (1-5)^{th} adhesive member 335.

According to an embodiment, at least one cover member 340 may be a tape made of a polyethylene terephthalate (PET) material. According to an embodiment, at least one cover member 340 may include a first cover member 341, a second cover member 342, a third cover member 343, a fourth cover member 344, a fifth cover member 345, or a sixth cover member 346.

According to an embodiment, the (1-1)^{th} adhesive member 331 may be disposed between the first heat-dissipation sheet 331 and the second heat-dissipation sheet 332. For example, the (1-1)^{th} adhesive member 331 may bond the first heat-dissipation sheet 331 and the second heat-dissipation sheet 332.

According to an embodiment, the thickness of the (1-1)^{th} adhesive member 331 (e.g., the thickness in the Z-axis direction in FIGS. 7 to 10) may be about 9 µm to about 11 µm. According to an embodiment, the thickness of the (1-1)^{th} heat-dissipation sheet 331 may be about 10 µm.

According to an embodiment, the thickness of the structure in which the first heat-dissipation sheet 311, the (1-1)^{th} adhesive member 331, and the second heat-dissipation sheet 312 are laminated (e.g., the thickness in the Z-axis direction of FIGS. 7 to 10) may be about 150 µm. According to an embodiment, the thicknesses of the first heat-dissipation sheet 311 and the second heat-dissipation sheet 312 may be substantially the same.

According to an embodiment, the (1-2)^{th} adhesive member 332 may bond at least a portion of the first heat-dissipation sheet 311 and at least a portion of the first support member 212. According to an embodiment, a portion of the (1-2)^{th} adhesive member 332 that does not come into contact with the first support member 212 may be covered by the first cover member 341.

According to an embodiment, the first cover member 341 may be disposed to cover a portion of the (1-2)^{th} adhesive member 332 facing the (2-1)^{th} hinge structure 280-21.

According to an embodiment, the second cover member 342 may be bonded to one surface of the second heat-dissipation sheet 312 (e.g., the surface oriented in the +Z direction in FIGS. 7 to 10).

According to an embodiment, the (1-3)^{th} adhesive member 333 may be bonded to at least a portion of the second cover member 342. The (1-3)^{th} adhesive member 333 may be positioned to overlap the (1-2)^{th} adhesive member 332 with reference to the thickness direction of the electronic device 101 (e.g., the Z-axis direction in FIGS. 7 to 10).

According to an embodiment, the third cover member 343 may be bonded to one surface of the (1-3)^{th} adhesive sheet 333 (e.g., the surface oriented in the +Z direction in FIGS. 7 to 10). According to an embodiment, the third cover member 343 may face at least a portion of the flexible display 230.

According to an embodiment, the (1-4)^{th} adhesive member 334 may bond at least a portion of the first cushion member 321 and at least a portion of the second support member 222. According to an embodiment, a portion of the (1-4)^{th} adhesive member 334 that does not come into contact with the second support member 222 may be covered by the fourth cover member 344.

According to an embodiment, the fourth cover member 344 may be disposed to cover a portion of the (1-4)^{th} adhesive member 334 facing the (2-2)^{th} hinge structure 280-22.

According to an embodiment, the second adhesive member 350 may bond at least a portion of one surface of the first cushion member 321 (e.g., the surface oriented in the +Z direction in FIG. 7) to at least a portion of the flexible display 230. According to an embodiment, the second adhesive member 350 may include at least one of a pressure-sensitive adhesive (PSA), an optical clear adhesive (OCA), a heat-reactive adhesive, a general adhesive, or a double-sided tape.

According to an embodiment, the second adhesive member 350 may be bonded to at least a portion of the flexible display 230. According to an embodiment, the second adhesive member 350 may reduce the occurrence of wrinkles in the flexible display 230 by directly supporting the at least a portion of the flexible display 230. For example, the second adhesive member 350 may reduce the occurrence of wrinkles in the portion of the flexible display 230 disposed on the second housing 220.

According to an embodiment, the second adhesive member 350 may be disposed between the flexible display 230 and the second support member 222 with reference to the thickness direction of the electronic device 101 (e.g., the Z-axis direction in FIGS. 7 to 10).

According to an embodiment, the thickness of the second adhesive member 350 (e.g., the thickness in the Z-axis direction in FIGS. 7 to 10) may be substantially equal to the first distance L1, which is a separation distance between the flexible display 230 and the first cushion member 321.

According to an embodiment, the gap adjustment member 360 may be disposed on at least a portion of one surface of the first cushion member 321 (e.g., the surface oriented in the +Z direction in FIGS. 7 to 10).

According to an embodiment, the gap adjustment member 360 may be a tape made of a polyethylene terephthalate (PET) material. According to an embodiment, the gap adjustment member 360 may be configured to occupy at least a portion of an empty space between the flexible display 230 and a portion of the first cushion member 321 where the second adhesive member 350 is not disposed. According to an embodiment, the gap adjustment member 360 may be configured to cover the empty space between the flexible display 230 and the first cushion member 321.

According to an embodiment, the gap adjustment member 360 may be disposed between the flexible display 230 and the (2-2)th hinge structure 280-22 with reference to the thickness direction of the electronic device 101 (e.g., the Z-axis direction in FIGS. 7 to 10).

According to an embodiment, the fifth cover member 345 may be bonded to one surface of the gap adjustment member 360 (e.g., the surface oriented in the +Z direction in FIGS. 7 to 10). According to an embodiment, the fifth cover member 345 may face at least a portion of the flexible display 230.

According to an embodiment, the sixth cover member 346 may be bonded to one surface of the second cushion member 322 (e.g., the surface oriented in the +Z direction in FIGS. 7 to 10). According to an embodiment, the sixth cover member 346 may face at least a portion of the flexible display 230.

Referring to FIG. 7, the first cushion member 321 and the second cushion member 322 may be provided as separate cushion members. The first cushion member 321 and the second cushion member 322 may be disposed adjacent to each other.

Referring to FIG. 8, the first cushion member 3211 (e.g., the first cushion member 321 in FIG. 7) and the second cushion member 3221 (e.g., the second cushion member 322 in FIG. 7) may be integrated.

Referring to FIG. 9, the display sheet member 300 may further include a third adhesive member 370.

According to an embodiment, the third adhesive member 370 may bond at least a portion of one surface of the second cover member 342 (e.g., the surface oriented in the +Z direction in FIG. 9) to at least a portion of the flexible display 230. According to an embodiment, the third adhesive member 370 may include at least one of a pressure-sensitive adhesive (PSA), an optical clear adhesive (OCA), a heat-reactive adhesive, a general adhesive, or a double-sided tape.

According to an embodiment, the third adhesive member 370 may be bonded to at least a portion of the flexible display 230. According to an embodiment, the third adhesive member 370 may reduce the occurrence of wrinkles in the flexible display 230 by directly supporting the at least a portion of the flexible display 230. For example, the third adhesive member 370 may reduce the occurrence of wrinkles in the portion of the flexible display 230 disposed on the first housing 210.

Referring to FIG. 10, the display sheet member 300 may further include a film layer 380.

According to an embodiment, the (1-1)^{th} adhesive member 331 may include a first adhesive layer 3311 and a second adhesive layer 3312. For example, the first adhesive layer 3311 may be bonded to a surface of the first heat-dissipation sheet 311 facing the second heat-dissipation sheet 312 (e.g., the surface oriented in the +Z direction in FIG. 10), and the second adhesive layer 3312 may be bonded to a surface of the second heat-dissipation sheet 312 facing the first heat-dissipation sheet 311 (e.g., the surface oriented in the -Z direction of FIG. 10).

According to an embodiment, the film layer 380 may be disposed between the first adhesive layer 3311 and the second adhesive layer 3312. For example, the film layer 380 may be bonded to the first adhesive layer 3311 and the second adhesive layer 3312.

According to an embodiment, the film layer 380 may be a polyimide film. According to an embodiment, the film layer 380 may be disposed between the first heat-dissipation sheet 311 and the second heat-dissipation sheet 312, thereby mitigating the impact transmitted from the first heat-dissipation sheet 311 to the second heat-dissipation sheet 312 or *vice versa.*

An electronic device (e.g., a portable terminal) includes a display having a flat surface or a display having a flat surface and a curved surface. An electronic device including an existing type of display may require another terminal when implementing a screen larger than the size of the electronic device due to the structure of a fixed display. Accordingly, electronic devices including a foldable or rollable display are being researched.

An electronic device may include multiple housings, and due to the structure of the multiple housings or the components disposed inside each housing, the required heat-dissipation performance or impact resistance for each housing may vary.

An embodiment of the disclosure may provide a flexible display with improved impact resistance and heat-dissipation performance and an electronic device including the same.

However, the problems that the disclosure seeks to solve are not limited to the aforementioned problems, and may be expanded in various ways without departing from the spirit and scope of the disclosure.

An embodiment of the disclosure may provide a flexible display that is less damaged by an external impact and an electronic device including the same.

The effects that are capable of being obtained by the disclosure are not limited to those described above, and other effects not described above may be clearly understood by a person ordinarily skilled in the art to which the disclosure belongs based on the following description.

According to an embodiment of the disclosure, an electronic device (e.g., the electronic device 101 in FIG. 1, or the electronic device 101 in FIGS. 2 to 10) may include a housing (e.g., the housing 202 in FIG. 2), a hinge structure (e.g., the hinge structure 280 in FIG. 4), a flexible display (e.g., the flexible display 230 in FIG. 4 or the flexible display 230 in FIGS. 7 to 10), at least one heat-dissipation sheet (e.g., the at least one heat-dissipation sheet 310 in FIGS. 6 to 10), or a cushion member (e.g., the cushion member 320 in FIGS. 6 to 10). The housing may include a first housing (e.g., the first housing 210 in FIGS. 2 to 10) or a second housing (e.g., the second housing 220 in FIGS. 2 to 10). The hinge structure may rotatably connect the first housing and the second housing. The flexible display may be disposed on the housing. The at least one heat-dissipation sheet may be disposed between the first housing and the flexible display. The cushion member may be disposed between the second housing and the flexible display. The cushion member may include a first cushion member (e.g., the first cushion member 321 in FIGS. 6 to 10) or a second cushion member (e.g., the second cushion member 322 in FIGS. 6 to 10). At least a portion of the first cushion member may be disposed between at least a portion of the hinge structure and the flexible display. The first cushion member may be spaced apart from the flexible display by a first distance (e.g., the first distance L1 in FIGS. 7 to 9). The second cushion member may be disposed adjacent to the first cushion member. The second cushion member may be spaced apart from the flexible display by a second distance (e.g., the second distance L2 in FIGS. 7 to 9) that is smaller than the first distance.

According to an embodiment, the first cushion member may be disposed between the at least one heat-dissipation sheet and the second cushion member when the electronic device is in an unfolded state.

According to an embodiment, the thickness of the first cushion member (e.g., the first thickness H1 in FIGS. 7 to 9) may be smaller than the thickness of the second cushion member (e.g., the second thickness H2 in FIGS. 7 to 9).

According to an embodiment, the electronic device may further include a gap adjustment member (e.g., the gap adjustment member 360 in FIGS. 7 to 9). The gap adjustment member may be bonded to at least a portion of the first cushion member. The gap adjustment member may face at least a portion of the flexible display.

According to an embodiment, the first cushion member (e.g., the first cushion member 3211 in FIG. 8) and the second cushion member (e.g., the second cushion member 3221 in FIG. 8) may be integrally formed.

According to an embodiment, the at least one heat-dissipation sheet may include a first heat-dissipation sheet (e.g., the first heat-dissipation sheet 311 in FIGS. 7 to 10) or a second heat-dissipation sheet (e.g., the second heat-dissipation sheet 312 in FIGS. 7 to 10). The second heat-dissipation sheet may be spaced apart from the first heat-dissipation sheet. The second heat-dissipation sheet may have a thickness substantially equal to that of the first heat-dissipation sheet.

In an embodiment, the electronic device may further include a first adhesive member (e.g., the (1-1)^{th} adhesive member 331 in FIGS. 6 to 10). The first adhesive member may be disposed between the first heat-dissipation sheet and the second heat-dissipation sheet. The first adhesive member may be configured to bond the first heat-dissipation sheet and the second heat-dissipation sheet.

According to an embodiment, the first adhesive member may include a pressure-sensitive adhesive (PSA).

According to an embodiment, the first adhesive member may include a first adhesive layer (e.g., the first adhesive layer 3311 in FIG. 10) or a second adhesive layer (e.g., the second adhesive layer 3312 in FIG. 10). The first adhesive layer may be disposed on a surface of the first heat-dissipation sheet facing the second heat-dissipation sheet. The second adhesive layer may be disposed on a surface of the second heat-dissipation sheet facing the first heat-dissipation sheet. The electronic device may further include a film layer (e.g., the film layer 380 in FIG. 10). The film layer may be disposed between the first adhesive layer and the second adhesive layer.

According to an embodiment, the film layer may be a polyimide film.

According to an embodiment, the electronic device may further include a second adhesive member (e.g., the second adhesive member 350 in FIGS. 7 to 10). The second adhesive member may be disposed between the first cushion member and the flexible display. The second adhesive member may further include a second adhesive member configured to bond the first cushion member and at least a portion of the flexible display.

According to an embodiment, the second adhesive member may include a pressure-sensitive adhesive (PSA).

According to an embodiment, the thickness of the second adhesive member may be substantially equal to the first distance.

According to an embodiment, the electronic device may further include at least one cover member (e.g., the second cover member 342 in FIGS. 7 to 10). The at least one cover member may be disposed on at least a portion of the at least one heat-dissipation sheet.

According to an embodiment, the electronic device may further include a third adhesive member (e.g., the third adhesive member 370 in FIG. 9). The third adhesive member may be disposed between the at least one cover member and the flexible display. The third adhesive member may be configured to bond the at least one cover member and at least a portion of the flexible display.

According to an embodiment of the disclosure, an electronic device (e.g., the electronic device 101 in FIG. 1, or the electronic device 101 in FIGS. 2 to 10) may include a housing (e.g., the housing 202 in FIG. 2), a hinge structure (e.g., the hinge structure 280 in FIG. 4), a flexible display (e.g., the flexible display 230 in FIG. 4 or the flexible display 230 in FIGS. 7 to 10), at least one heat-dissipation sheet (e.g., the at least one heat-dissipation sheet 310 in FIGS. 6 to 10), or a cushion member (e.g., the cushion member 320 in FIGS. 6 to 10). The housing may include a first housing (e.g., the first housing 210 in FIGS. 2 to 10) or a second housing (e.g., the second housing 220 in FIGS. 2 to 10). The hinge structure may rotatably connect the first housing and the second housing. The flexible display may be disposed on the housing. The at least one heat-dissipation sheet may be disposed between the first housing and the flexible display. The cushion member may be disposed between the second housing and the flexible display. The cushion member may include a first cushion member (e.g., the first cushion member 321 in FIGS. 6 to 10) or a second cushion member (e.g., the second cushion member 322 in FIGS. 6 to 10). At least a portion of the first cushion member may be disposed between at least a portion of the hinge structure and the flexible display. The first cushion member may have a first thickness (e.g., the first thickness H1 in FIGS. 7 to 9) in a first direction (e.g., the Z-axis direction in FIGS. 7 to 10). The second cushion member may be disposed adjacent to the first cushion member. The second cushion member may have a second thickness (e.g., the second thickness H2 in FIGS. 7 to 9) that is greater than the first thickness in the first direction.

According to an embodiment, the electronic device may include a first printed circuit board (e.g., the first printed circuit board 262 in FIG. 4 or the first printed circuit board 262 in FIGS. 7 to 10), or a second printed circuit board (e.g., the second printed circuit board 264 in FIG. 4 or the second printed circuit board 264 in FIGS. 7 to 9). The first printed circuit board may be disposed in the first housing. The second printed circuit board may be disposed in the second housing.

According to an embodiment, the at least one heat-dissipation sheet may include a first heat-dissipation sheet (e.g., the first heat-dissipation sheet 311 in FIGS. 7 to 10) or a second heat-dissipation sheet (e.g., the second heat-dissipation sheet 312 in FIGS. 7 to 10). The second heat-dissipation sheet may be spaced apart from the first heat-dissipation sheet. The second heat-dissipation sheet may have a thickness substantially equal to that of the first heat-dissipation sheet.

In an embodiment, the electronic device may further include a first adhesive member (e.g., the (1-1)^{th} adhesive member 331 in FIGS. 6 to 10). The first adhesive member may be disposed between the first heat-dissipation sheet and the second heat-dissipation sheet. The first adhesive member may be configured to bond the first heat-dissipation sheet and the second heat-dissipation sheet.

According to an embodiment, the electronic device may further include a second adhesive member (e.g., the second adhesive member 350 in FIGS. 7 to 10). The second adhesive member may be disposed between the first cushion member and the flexible display. The second adhesive member may further include a second adhesive member configured to bond the first cushion member and at least a portion of the flexible display.

In the foregoing detailed description of this document, specific embodiments have been described. However, it will be evident to a person ordinarily skilled in the art that various modifications can be made without departing from the scope of the disclosure.

## Claims

1. An electronic device (101) comprising:
a housing (202) comprising a first housing (210) and a second housing (220);
a hinge structure (280) rotatably connecting the first housing and the second housing;
a flexible display (230) disposed on the housing;
at least one heat-dissipation sheet (310) disposed between the first housing and the flexible display; and
a cushion member (320) disposed between the second housing and the flexible display,
wherein the cushion member comprises:
a first cushion member (321) at least a portion of which is disposed between at least a portion of the hinge structure and the flexible display and is spaced apart from the flexible display by a first distance (L1); and
a second cushion member (322) disposed adjacent to the first cushion member and spaced apart from the flexible display by a second distance (L2) smaller than the first distance.

2. The electronic device of claim 1, wherein the first cushion member is disposed between the at least one heat-dissipation sheet and the second cushion member when the electronic device is in an unfolded state.

3. The electronic device of one of claims 1 and 2, wherein a thickness (H1) of the first cushion member is smaller than a thickness (H2) of the second cushion member.

4. The electronic device of one of claims 1 to 3, further comprising:
a gap adjustment member (360) bonded to at least a portion of the first cushion member and facing at least a portion of the flexible display.

5. The electronic device of one of claims 1 to 4, wherein the first cushion member (3211) and the second cushion member (3221) are integrally formed.

6. The electronic device of one of claims 1 to 5, wherein the at least one heat-dissipation sheet comprises:
a first heat-dissipation sheet (311); and
a second heat-dissipation sheet (312) spaced apart from the first heat-dissipation sheet and having a thickness substantially equal to a thickness of the first heat-dissipation sheet.

7. The electronic device of one of claims 1 to 6, further comprising:
a first adhesive member (331) disposed between the first heat-dissipation sheet and the second heat-dissipation sheet and configured to bond the first heat-dissipation sheet and the second heat-dissipation sheet.

8. The electronic device of one of claims 1 to 7, wherein the first adhesive member comprises a pressure-sensitive adhesive PSA.

9. The electronic device of one of claims 1 and 8, wherein the first adhesive member comprises:
a first adhesive layer (3311) disposed on a surface of the first heat-dissipation sheet facing the second heat-dissipation sheet; and
a second adhesive layer (3312) disposed on a surface of the second heat-dissipation sheet facing the first heat-dissipation sheet, and
wherein the electronic device further comprises a film layer (380) disposed between the first adhesive layer and the second adhesive layer.

10. The electronic device of one of claims 1 to 9, wherein the film layer is a polyimide film.

11. The electronic device of one of claims 1 to 10, further comprising:
a second adhesive member (350) disposed between the first cushion member and the flexible display and configured to bond the first cushion member and at least a portion of the flexible display.

12. The electronic device of one of claims 1 to 11, wherein the second adhesive material comprises a pressure-sensitive adhesive (PSA).

13. The electronic device of one of claims 1 to 12, wherein a thickness of the second adhesive member is substantially equal to the first distance.

14. The electronic device of one of claims 1 to 13, further comprising:
at least one cover member (342) disposed on at least a portion of the at least one heat-dissipation sheet.

15. The electronic device of one of claims 1 to 14, further comprising:
a third adhesive member (370) disposed between the at least one cover member and the flexible display and configured to bond the at least one cover member and at least a portion of the flexible display.
